# EUROPÄISCHE PATENTSCHRIFT

(11) **EP 2 558 906 B1**
(45) Veröffentlichungstag und Bekanntmachung des Hinweises auf die Patenterteilung: **19.03.2014**
(21) Anmeldenummer: 11713685.3
(22) Anmeldetag: 02.04.2011
(51) Int. Cl.: G03F 1/22

(54) **RÖNTGENLITHOGRAPHIEMASKE AUS NICKEL ODER EINER NICKELBASISLEGIERUNG**
MASK FOR X-RAY LITHOGRAPHIE COMPRISING NICKEL OR NICKEL ALLOY
MASQUE DE RADIOLITHOGRAPHIE FABRIQUÉ EN NICKEL OU DANS UN ALLIAGE À BASE DE NICKEL

(30) Priorität: 16.04.2010 DE 102010015124
(43) Veröffentlichungstag der Anmeldung: 20.02.2013
(73) Patentinhaber: Karlsruher Institut für Technologie, 76131 Karlsruhe (DE)
(72) Erfinder: SCHULZ, Joachim, 76137 Karlsruhe (DE); WALTER, Marco, 76131 Karlsruhe (DE)
(86) Internationale Anmeldenummer: PCT/EP2011/001669
(87) Internationale Veröffentlichungsnummer: WO 2011/128031

(56) Entgegenhaltungen:
- EP-A2- 0 323 263
- WO-A1-89/03544
- US-A- 4 634 643
- SHAN X C ET AL: "Optimization of Au mask fabrication processes for LIGA applications", PROCEEDINGS OF THE SPIE - THE INTERNATIONAL SOCIETY FOR OPTICAL ENGINEERING SPIE-INT. SOC. OPT. ENG. USA, Bd. 4936, 18. Dezember 2002 (2002-12-18), Seiten 356-364, XP002640855, ISSN: 0277-786X
- MAPPES T ET AL: "Submicron polymer structures with X-ray lithography and hot embossing", MICROSYSTEM TECHNOLOGIES SPRINGER-VERLAG GERMANY, Bd. 14, Nr. 9-11, 9. Januar 2008 (2008-01-09), Seiten 1721-1725, XP002640856, ISSN: 0946-7076

## Beschreibung

Die vorliegende Erfindung betrifft eine Röntgenlithographiemaske aus Nickel oder einer Nickelbasislegierung, ein Verfahren zu ihrer Herstellung und ihre Verwendung.

Für viele Anwendungen, wie beispielsweise in der Präzisions- und Hochpräzisionstechnologie werden lithografische Verfahren eingesetzt, die besondere Anforderungen an die verwendeten Masken stellen. Ein häufig verwendetes Verfahren ist die Röntgenlithographie, die Masken voraussetzt, wobei hochpräzise Maskenstrukturen typischerweise mit elektronenstrahllithographischen Verfahren erzeugt werden.

Die US 4,058,432 offenbart die Herstellung galvanisch abgeschiedener Schichten als Membranen. Derartige Membranen werden durch einen Ätzschritt von der Trägerschicht freigelegt. Im in der Schrift beschriebenen Anwendungsbeispiel wird die Verwendung solcher Membranen mit mikrostrukturierten Öffnungen als sogenannte Stencil Maske erwähnt. Die Membran wirkt also effektiv als Absorber für Ionen- oder Elektronenstrahlen. Als eine weitere Schrift zu Stencil Masken ist die US 4,370,556 zu nennen. Sie offenbart eine Methode zur Erzielung einer mechanischen Spannung in einer Membran, die ebenfalls mikrostrukturierte Öffnungen aufweist, wobei die mechanische Spannung thermisch induzierte Verzüge beim Bestrahlen mit Elektronen- oder Ionenstrahlen erheblich vermindert.

Bekannte Röntgenmasken bestehen aus einem Rahmen, auf dem eine Membran aufgespannt ist und wobei auf der Membran eine Absorberschicht aufgebracht ist. In der EP0720756wird offenbart, dassals Röntgenmaske Membranen aus Titan oder Titan mit Beryllium mit Absorbern aus Gold und einer Zwischenschicht aus Chrom eingesetzt werden, die das gewünschte Muster aus durchlässigen und nicht durchlässigen Teilbereichen ergeben.

Zur Herstellung von Röntgenmasken werden Verfahren eingesetzt, die das Aufsputtern einer Kohlenstoffschicht, gefolgt vom Aufsputtern einer Titanschicht umfassen *(vgl.* Desta, Y und Goettert, J; X-ray Masks for LIGA Microfabrication; in: LIGA and ist applications, Saile, V; Wallrabe U, Tabata O., Korvink J.G. (eds) Wiley-VCH (2009*)).* Die Titanschicht muss eine ausreichende Reißfestigkeit aufweisen und über eine geringe Haftung auf dem kohlenstoffbeschichteten Substrat verfügen. Gleichzeitig muss eine hinreichende Defektfreiheit und Konstanz der inneren Spannungen gewährleistet sein, damit die Titanschicht als Membran funktionieren kann. Obwohl es technisch möglich ist, derartige Schichten herzustellen, beschränkt man sich auf Masken bis zu einer freien Membrangröße von ca. bis zu 3 Zoll, da für größere Membranen die Kosten auf Grund sinkender Ausbeute nur sehr kostenintensiv herzustellen sind.

Bislang sind keine Röntgenmasken bekannt, die über größere freie Membranflächen als die eingangs erwähnten 3 Zoll verfügen und für Anwendungen mit weicher Röntgenstrahlung (etwa 3 bis 4 keV) genutzt werden können. Mit der etablierten LIGA Technik ist es bisher nicht gelungen größere Flächen unter Beibehaltung höchster Strukturgenauigkeiten, wie sie zum Beispiel mit Elektronenstrahllithographie hergestellt werden können zu erzeugen.

Bekannt sind zwar Lithographiemasken die als Röntgenmasken Verwendung finden, bei denen die Membran aus Polyimid besteht da die Herstellung von Polyimidmembranen mit großen Flächen über Spin-Coating Prozesse kostengünstig realisierbar ist. Polyimidmembranen verfügen jedoch über hohe thermische Ausdehnungskoeffizienten und einen sehr geringen E-Modul. Thermische Belastungen beim Bestrahlen wirken sich daher qualitätsmindernd aus. Insbesondere die laterale Bewegung der Maske durch Temperaturschwankungen führt zu unerwünschter Bestrahlung von Resistbereichen, wie in Achenbach, S; Boerner, M et.al, Structure quality in deep X-ray lithography applying commercial polyimide-based masks; MICROSYSTEM TECHNOLOGIES-MICRO-AND NANOSYSTEMS-INFORMATION STORAGE AND PROCESSING SYSTEMS, 13 (3-4): 349-353 FEB 2007 beschrieben ist.

Aus dem allgemeinen Stand der Technik sind weitere Membranmaterialien für weiche Röntgenstrahlung bekannt, so zum Beispiel Si₃N₄ und Diamant, jedoch haben diese Materialien gegenüber Titan den Nachteil, dass die freitragenden Flächen noch kleiner sind als bei Titan, so dass Titanmembranen bevorzugt eingesetzt werden. In Pantenburg, F.J.; Mohr, J. Influence of Secondary Effects on the Strucutre Quality in Deep X-Ray-Lithography; NUCLEAR INSTRUMENTS & METHODS IN PHYSICS RESEARCH SECTION B-BEAM INTERACTIONS WITH MATERIALS AND ATOMS, 97 (1-4): 551-556 MAY 1995 ist jedoch offenbart, dass bei Membranen aus Titan bei einer Bestrahlung mit dem breit verteilten Spektrum eines Synchrotrons eine Fluoreszenzstrahlung aus dem Membranmaterial auftreten, was sich nachteilig auf die Bestrahlungspräzision auswirkt.

Ausgehend davon liegt die **Aufgabe der Erfindung** darin, eine Röntgenlithographiemaske, ein Verfahren zu ihrer Herstellung und ihre Verwendung vorzuschlagen, die die aufgeführten Nachteile und Einschränkungen vermeidet. Insbesondere soll eine Röntgenlithographiemaske angegeben werden, die über eine Membranfläche verfügt, die größer als 3 Zoll ist und die für Anwendungen in der Röntgentiefenlithografie geeignet ist.

Gelöst wird diese Aufgabe im Hinblick auf die Röntgenlithographiemaske mit einer Maske mit den Merkmalen nach Anspruch 1, im Hinblick auf das Verfahren durch die Verfahrensschritte gemäß des Anspruchs 6 und im Hinblick auf die Verwendung gemäß des Anspruchs 9. Die Unteransprüche geben vorteilhafte Ausgestaltungen der Erfindung an.

Zur Lösung der Aufgabe wird eine Röntgenlithographiemaske vorgeschlagen, die einen Rahmen und eine darauf gespannte Membran umfasst, wobei die Membran aus Nickel oder einer Nickelbasislegierung besteht und zumindest teilweise mit einer Absorberschicht versehen ist.

Für Anwendungen in der Präzisions- und Hochpräzisionstechnologie müssen die Röntgenlithographiemasken auf den Maskenrahmen gespannt sein, um eine Durchbiegung zu vermeiden. Dies wird durch den Einsatz von Nickel oder einer Legierung auf Nickelbasis ermöglicht, da das Material einen hinreichend hohen E-Modul und eine hohe Reißfestigkeit aufweist. Durch diese Eigenschaft können ausgedehnte, gespannte Membranflächen hergestellt werden.

Darüber hinaus eignen sich Nickel oder eine Nickelbasislegierung aufgrund ihrer Haftungseigenschaften zur Herstellung einer Membran. Auf Metallen, die an Luftsauerstoff eine passive Oberfläche bilden, ist die Haftung von galvanisch abgeschiedenem Nickel oder einer Legierung auf Nickelbasis gering. Dies wirkt sich vorteilhaft auf das erfindungsgemäße Verfahren aus, das eine kostengünstige Herstellung großflächiger Nickelschichten mit Schichtdicken von einigen wenigen Mikrometern ermöglicht. Die Schichten lassen sich dann nach dem Aufbringen leicht abziehen. Geringe Schichtdicken sind entscheidend für die Transparenz der Maskenmembran gegenüber der bei der Bestrahlung benutzten Strahlenquelle. Für die Röntgentiefenlithographie liegt die Schichtdicke bei einem Wert von 1 bis 2 µm, wobei die Dicke über die gesamte Membranfläche konstant ist.

Zur Herstellung einer erfindungsgemäßen Röntgenlithographiemaske sind folgende Verfahrensschritte auszuführen. Zunächst wird einSubstrat mit einer hinreichenden Ebenheit bereitgestellt. Nachfolgend wird eine einige Mikrometer dicke Schicht aus reinem Nickel oder einer Legierung auf Nickelbasis aufgebracht. Auf die Nickelschicht wird ein Resist flächig aufgebracht und das gewünschte Muster wird mittels eines Elektronenlithographieverfahrens in das Resistmaterial eingebracht und entwickelt. Danach wird eine Absorberschicht abgeschieden und der Resist wird entfernt. Um die Maskenmembran auf den Maskenrahmen zu spannen, werden alle Bauteile erwärmt wobei sich eine Temperatur im Bereich von ca. 30°C bis ca. 90°C als geeignet erwiesen hat. Der Rahmen besteht dabei aus einem Material, das einen geringeren Wärmeausdehnungskoeffizienten hat als die verwendete Nickellegierung oder reines Nickel. Nach dem Abkühlen ist somit sicher gestellt, dass die Nickelmembran auf den Maskenrahmen aufgespannt und eben ist. Als letzten Verfahrensschritt wird die Membran vom Substrat getrennt und die fertige Maske wird abhoben.

Nachfolgend wird die Erfindung anhand von Beispielen und der Figuren näher erläutert.

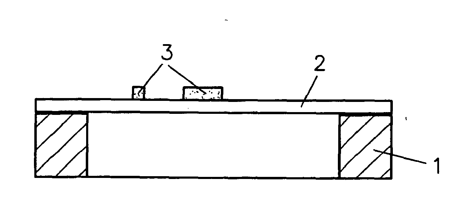

Figur 1 zeigt schematisch eine Röntgenlithographiemaske, einen Maskenrahmen aus Invar **1** mit aufgespannter Membran aus Nickel **2,** die teilweise mit einer Absorberschicht **3** aus Gold versehen ist.

Zur Herstellung einer derartigen Röntgenlithographiemaske wurde eine Schicht aus reinem Nickel **2,** mit einer Schichtdicke von 2 µm, galvanisch auf ein Substrat aufgebracht. Das Substrat hat in einer Ausführform eine Größe von 6 Zoll und weist eine passive Oberfläche auf, so dass das Nickel gut galvanisch startet aber schlecht haftet. Eine Absorberstruktur aus Gold wurde durch Belichtung einer Resistschicht auf dem Substrat an einem Mask-Aligner, mit anschließender Galvanik hergestellt. Nachfolgend wurde die Anordnung auf ca. 50°C erwärmt und ein ebenfalls auf diese Temperatur erwärmter Rahmen aus Invar wurde aufgeklebt. Nach dem Abkühlen wurde mittels eines Skalpells die Nickelmembran aufgetrennt und von dem Substrat abgehoben. Bezüglich der freien Membranfläche kann durch Verwendung entsprechend größerer Substrate die Membranfläche auf bis zu 17 Zoll vergrößert werden.

Die Herstellung hochpräziser Röntgenlithographiemasken erfordert eine hochpräzise Strukturierung der Absorber. Hierfür wird die Elektronenstrahllithographie mit anschließender Galvanik von Gold in die Resiststrukturen eingesetzt. Zur Strukturierung von großen Flächen in einer Elektronenstrahlanlage ist ein ebenes Substrat notwendig, dessen Oberfläche sicher im Fokusbereich der Anlage von nur einigen zehn Mikrometern liegt. Hierfür eignen sich zum Beispiel Glasplatten wie sie für die Herstellung von Chrommasken verwendet werden oder Silizium-Wafer. Die Strukturierung einer erfindungsgemäßen Röntgenlithographiemaske erfolgt auf solch einem Substrat in einer Elektronenstrahlanlage.

Besonders vorteilhaft hat sich die Verwendung von Röntgenlithographiemasken mit Nickelmembranen bei der Röntgentiefenlithographie von 20 bis 100 µm dicken Resistschichten mit weicher Synchrotronstrahlung zwischen 2,5 und 6 keV erwiesen. Bei der Belichtung der Resistschicht durch die erfindungsgemäße Maske wird beispielsweise jegliche Fluoreszenzstrahlung beim Einsatz einer Synchrotronquelle mit 1,3 GeV vermieden, da die zugehörige Absorptionskante des Nickels bei 8,3 keV liegt und im Spektrum der Synchrotronquelle bei 8,3 keV nahezu keine Leistung mehr vorhanden ist.

### Bezugszeichenliste

- 1: Maskenrahmen
- 2: Aufgespannte Membran
- 3: Absorberschicht

## Patentansprüche

1. Röntgenlithographiemaske umfassend einen Rahmen (1) und eine Membran (2) aus einem Metall, wobei die Membran (2) auf den Rahmen (1) gespannt ist,
**dadurch gekennzeichnet, dass**
die Membran (2) aus Nickel oder aus einer Nickelbasislegierung besteht und wobei die Membran (2) zumindest teilweise mit einer Absorberschicht (3) bedeckt ist.

2. Röntgenlithographiemaske nach Anspruch 1, wobei die Membran (2) eine Dicke von 1-2 µm aufweist.

3. Röntgenlithographiemaske nach Anspruch 1 oder 2, wobei der Rahmen (1) aus einem Werkstoff besteht, der einen geringeren Wärmeausdehnungskoeffizienten als Nickel hat.

4. Röntgenlithographiemaske nach einem der Ansprüche 1 bis 3, wobei die Membran (2) auf den Rahmen (1) durch Kleben aufgespannt ist.

5. Röntgenlithographiemaske nach einem der Ansprüche 1 bis 4, wobei die Absorberschicht (3) aus Gold oder einer Goldlegierung besteht.

6. Verfahren zur Herstellung einer Röntgenlithographiemaske nach Anspruch 1 umfassend die folgenden Verfahrensschritte
- Bereitstellen eines Substrats
- Aufbringen einer Schicht aus Nickel oder einer Nickelbasislegierung
- Aufbringen eines Resists
- Strukturieren des Resists mit einem Lithographieverfahren
- Entwickeln des Resists
- Abscheiden einer Absorberschicht
- Entfernen des Resists
- Aufkleben des Rahmens
- Ablösen der Membran aus Nickel oder einer Nickelbasislegierung mit dem Rahmen vom Substrat
- Entnehmen der Lithographiemaske

7. Verfahren nach Anspruch 6, wobei das lithographische Strukturierungsverfahren ein Elektronenstrahlverfahren ist.

8. Verfahren nach Anspruch 6, wobei der Rahmen (1) und das Substrat mit der Membran (2) vor dem Aufkleben erwärmt werden.

9. Verwendung der Röntgenlithographiemaske nach Anspruch 1 als Maske für das Röntgentiefenlithographieverfahren.

## Claims

1. X-ray lithography mask comprising a frame (1) and a membrane (2) of a metal,
wherein the membrane (2) is clamped onto the frame (1),
**characterized in that** the membrane (2) consists of nickel or a nickel-based alloy and wherein the membrane (2) is covered at least partly with an absorber layer (3).

2. X-ray lithography mask according to claim 1, wherein the membrane (2) has a thickness of 1 - 2 µm.

3. X-ray lithography mask according to claim 1 or 2, wherein the frame (1) consists of a material which has a lower thermal expansion coefficient than nickel.

4. X-ray lithography mask according to any one of claims 1 to 3, wherein the membrane (2) is clamped onto the frame (1) by adhesive bonding.

5. X-ray lithography mask according to any one of claims 1 to 4, wherein the absorber layer (3) consists of gold or a gold alloy.

6. Method for producing an X-ray lithography mask according to claim 1, comprising the following method steps:
- provision of a substrate
- application of a layer of nickel or a nickel-based alloy
- application of a resist
- structuring of the resist with a lithography process
- developing of the resist
- deposition of an absorber layer
- removal of the resist
- adhesive bonding of the frame
- detachment of the membrane of nickel or a nickel-based alloy with the frame from the substrate
- removal of the lithography mask.

7. Method according to claim 6, wherein the lithographic structuring process is an electron beam process.

8. Method according to claim 6, wherein the frame (1) and substrate with the membrane (1) are heated before bonding.

9. Use of the X-ray lithography mask according to claim 1 as a mask for the X-ray depth lithography process.

## Revendications

1. Masque de radiolithographie comprenant un cadre (1) et une membrane (2) réalisée en un métal, cette membrane (2) étant tendue sur le cadre (1),
**caractérisé en ce que**
la membrane (2) est réalisée en nickel ou en un alliage de nickel et est recouverte au moins partiellement par une couche d'absorbeur (3).

2. Masque de radiolithographie conforme à la revendication 1, dans lequel la membrane (2) a une épaisseur de 1 à 2 µm.

3. Masque de radiolithographie conforme à la revendication 1 ou 2, dans lequel le cadre (1) est réalisé en un matériau qui présente un coefficient de dilatation thermique inférieur à celui du nickel.

4. Masque de radiolithographie conforme à l'une des revendications 1 à 3, dans lequel la membrane (2) est tendue sur le cadre (1) au moyen de colle.

5. Masque de radiolithographie conforme à l'une des revendications 1 à 4, dans lequel la couche d'absorbeur (3) est réalisée en or ou en un alliage d'or.

6. Procédé d'obtention d'un masque de radiolithographie conforme à la revendication 1, comprenant les étapes consistant à :
- préparer un substrat,
- appliquer une couche de nickel ou d'un alliage de nickel,
- appliquer un résiste,
- structurer ce résiste par un procédé de lithographie,
- développer le résiste,
- déposer une couche d'absorbeur,
- enlever le résiste,
- coller le cadre,
- séparer la membrane réalisée en nickel ou en un alliage de nickel avec le cadre du substrat,
- prélever le masque de lithographie.

7. Procédé conforme à la revendication 6, selon lequel le procédé de structuration lithographique est un procédé de bombardement électronique.

8. Procédé conforme à la revendication 6, selon lequel le cadre (1) et le substrat sont chauffés avec la membrane (2) avant le collage.

9. Utilisation d'un masque de radiolithographie conforme à la revendication 1, entant que masque pour un procédé de radiolithographie en profondeur.
